# EUROPEAN PATENT APPLICATION

(11) **EP 0 891 128 A1**
(43) Date of publication of application: **13.01.1999**
(21) Application number: 98305442.0
(22) Date of filing: 08.07.1998
(51) Int. Cl.: H05K 3/36, H01R 9/09

(54) **Circuit board**

(30) Priority: 11.07.1997 GB 9714558
(71) Applicant: Lucas S.E.I. Wiring Systems Limited, Solihull B90 4LA (GB)
(72) Inventor: Barber, Gordon Robert, Stoke on Trent, Staffordshire ST4 6LX (GB)
(74) Representative: Carpenter, David

(57) **Abstract**

The invention relates to a circuit board assembly and to a method of assembling a circuit board assembly comprising the steps of providing first and second circuit boards (10, 12), electrically connecting the circuit boards (10, 12) to one another using a comb connector (20) comprising a plurality of conductive connecting elements interconnected by a spine (22), mounting components (16) upon the circuit boards (10, 12) whilst the circuit boards (10, 12) are oriented in a substantially coplanar manner, bending the connecting elements of the comb connector (20) until the boards are substantially parallel to one another, and breaking the spine (22) in at least one place to isolate one or more of the elements of the comb connector from adjacent elements thereof.

## Description

This invention relates to an assembly of printed circuit boards of the type in which a pair of circuit boards are mounted parallel to one another with electrical/electronic components mounted upon both sides of the assembly.

It is common to mount printed circuit boards upon one another in order to increase the area available for occupation by electrical/electronic components. In such arrangements, it is often necessary to provide electrical connections between the circuit boards. Such connections may be achieved by providing opening in the boards, and passing wires or connecting pins through the openings. Other techniques include passing wires over the edges of the assembly of circuit boards.

During manufacture of printed circuit boards, it is convenient to use flow soldering techniques to secure and electrically connect components to the boards. However, in order to use such a technique on an assembly of boards, the boards must be coplanar. Such techniques therefore cannot be used if the boards have already been mounted upon one another. German Patent Application 3842572 discloses a circuit board construction where first and second circuit boards are electrically interconnected by connector device consisting of a plurality of conductive connector elements secured together in electrically insulated relationship by a moulded plastic body, the elements, after being connected to the circuit boards, being bent to allow the boards to overlie one another, the teaching being to provide a specially moulded body to hold the elements in position relative to one another after they have been severed from an integral interconnecting member.

According to a first aspect of the invention there is provided a circuit board assembly comprising first and second circuit boards arranged parallel to each other, and comb connector means having a plurality of conductive connector elements providing a connection between conducting tracks adjacent an edge of the first circuit board and conducting tracks adjacent an edge of the second board; said plurality of conductive elements of said comb connector originally having been interconnected by an integral spine, the spine being broken in at least one place to isolate one or more conductive elements from adjacent elements after the elements have been secured to the boards.

The invention also relates to a method of assembling a printed circuit board assembly comprising the steps of providing first and second circuit boards, electrically connecting the circuit boards to one another using a comb connector comprising a plurality of conductive connecting elements interconnected by a spine, mounting components upon the circuit boards whilst the circuit boards are oriented in a substantially coplanar manner, bending the connecting elements of the comb connector until the boards are substantially parallel to one another, and breaking the spine in at least one place to isolate one or more of the elements of the comb connector from adjacent elements thereof.

Preferably said components and the connecting elements of the comb connector are electrically connected to tracks of the circuit boards by a flow soldering technique.

Preferably said spine is broken after bending of the connecting elements to position the boards parallel.

Alternatively said spine is broken before bending of the connecting elements to position the boards parallel.

The use of a comb connector in providing the electrical connection between the boards is advantageous in that as the boards are substantially coplanar, a flow soldering technique can be used to mount the components thereon, the boards subsequently being moved to lie substantially parallel to one another by bending the conductive elements of the comb connector, the elements being held in position relative to one another by their spine prior to connection to the tracks of the boards.

The invention will further be described, by way of example, with reference to the accompanying drawings, in which:
Figure 1 is a diagrammatic view of an assembly in accordance with an embodiment of the invention;
Figure 2 is a view of the arrangement of Figure 1 during assembly; and
Figures 3 to 5 are plan, side and underside views of the embodiment illustrated diagrammatically in Figures 1 and 2.

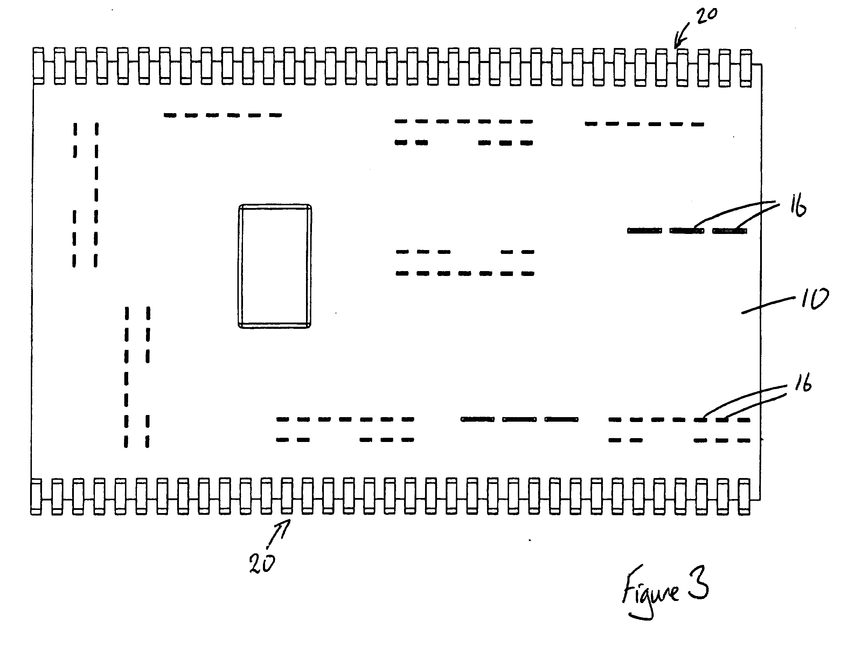

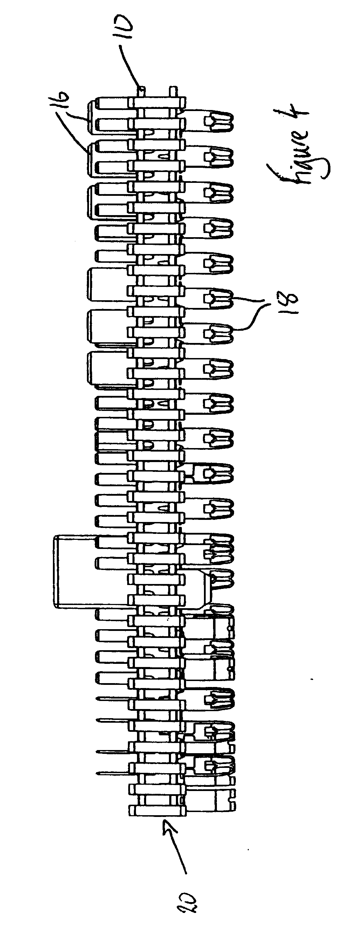

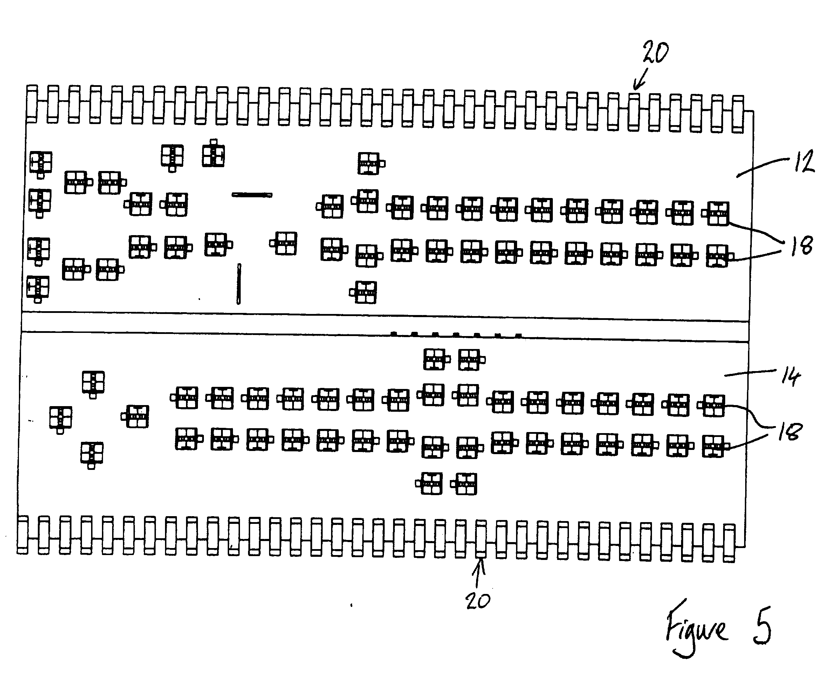

The accompanying drawings illustrate a circuit board assembly which comprises an upper printed circuit board 10 of substantially conventional form and a pair of lower printed circuit boards 12, 14 also of substantially conventional form. As illustrated in Figures 3 and 4, the upper circuit board 10 carries a plurality of electronic and electrical components 16, some of which take the form of terminal pins arranged to be received by corresponding connectors. Each of the components 16 includes one or more terminals which extend through openings provided in the upper circuit board 10, the terminals being electrically connected to conductive tracks printed upon the lower surface of the upper circuit board 10. Figures 4 and 5 illustrate that the lower surfaces of the lower circuit boards 12, 14 each carry a plurality of terminal clips 18 for use in supporting fuses. The terminal clips 18 each include a terminal which extends through a respective opening provided in the respective lower circuit board, and is soldered to electrically conductive tracks which are printed upon the upper surfaces of the lower printed circuit boards 12, 14.

The upper and lower circuit boards 10, 12, 14 are electrically connected to one another by means of comb connectors 20 each of which is stamped or otherwise formed from metal strip and includes a plurality of U-shaped connector elements 21 each having a pair of parallel legs, the elements being initially integral with one another by way of a spine 22 of the strip interconnecting the bases of the U-shaped elements. In use each comb connector can be handled as a unitary device. Each element of each comb connector has one leg of its pair electrically connected to the printed circuit of the upper board 10 whilst the other leg of each pair is electrically connected to the circuits of one of the lower boards 12, 14. It will be appreciated, therefore, that the comb connectors 20 provide electrical connections between the components 16 provided on the upper circuit board 10 and the fuse terminal clips 18 provided on the lower circuit board 12, 14.

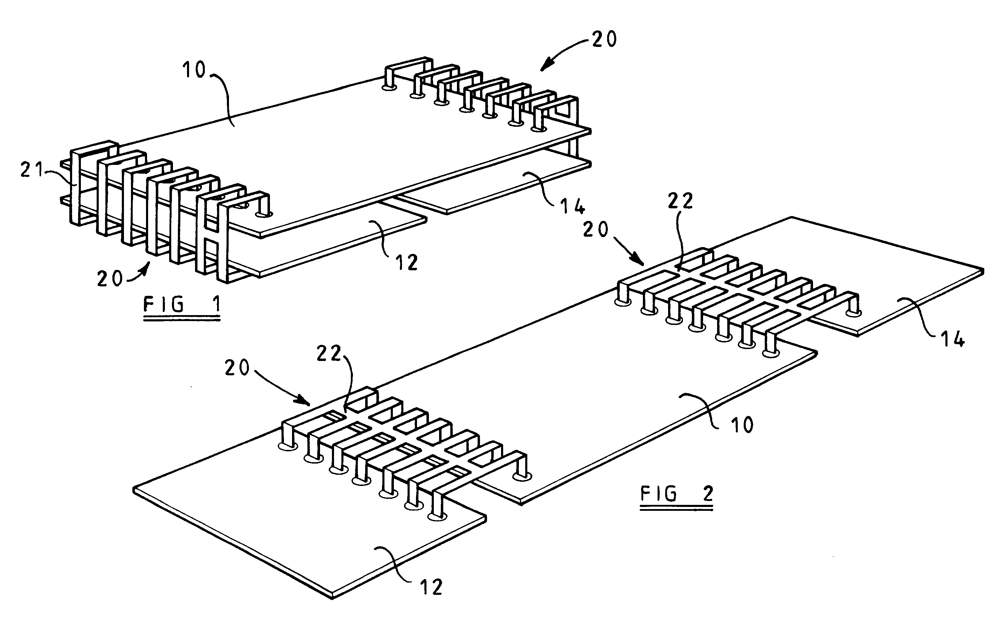

Figure 2 illustrates a step in the assembly of the circuit board arrangement of Figures 1 and 3 to 5. In Figure 2 the circuit boards 10, 12, 14 are arranged in a substantially coplanar orientation, the comb connectors 20 providing electrical connections between the printed circuits of the circuit boards. As illustrated in Figure 2, at this stage in the assembly process, the pairs of legs of each comb connector 20 are interconnected by the spine 22. Whilst the circuit boards 10, 12, 14 occupy the substantially coplanar orientation illustrated in Figure 2, the electrical or electronic components 16 and fuse terminal clips 18 are mounted in the appropriate positions upon the circuit boards 10, 12, 14 and are soldered to the electrically conductive tracks of the circuit boards 10, 12, 14 using a flow soldering technique, such a technique only being possible whilst the circuit boards are substantially coplanar. It will be appreciated that if one or more of the circuit boards occupies a position which is not coplanar with the other boards, then using a flow soldering technique to electrically connect the components to the electrically conductive tracks would not be possible for the components mounted upon at least one of the boards.

After the components 16 and terminal clips 18 have been mounted upon the circuit boards in their appropriate positions, the legs and/or base of the comb elements 21 are bent and the circuit boards moved until the circuit boards occupy the position illustrated in Figure 1. Once this position has been achieved, where appropriate, the spines 22 of the comb connectors 20 are cut to break the electrical connection provided by the spines between adjacent elements. It will be appreciated, however, that it may not be desirable to break the electrical connection between all adjacent pairs of elements in all circumstances, for example where a high current must flow between the circuits of one circuit board and the circuits of another (see Figure 1) relevant spine portions may be left in tact to preserve an electrical connection between adjacent elements 21. Moreover it is possible to sever the selected spine portions prior to the step of bending the comb elements if desired, such a method being more readily employed where the boards and/or elements are supported by a jig during bending.

Although not illustrated in the accompanying drawings, it will be appreciated that where necessary, an appropriate heat sink arrangement may be located between the upper circuit board and the lower circuit boards.

In the illustrated embodiment, the lower circuit boards 12, 14 together are of substantially equal area to that of the upper circuit board 10. It will be appreciated however that the invention is applicable to other circuit board arrangements, for example where only a single lower circuit board is provided, that circuit board being of area substantially equal to the area of the upper circuit board. In such an arrangement, only a single comb connector would be required. In another example, four lower circuit boards are used, each lower circuit board being electrically connected to an edge of the upper circuit board by an associated comb connector which extends along substantially the complete width of the respective edge of the upper board. The lower boards are conveniently of triangular form. The use of this arrangement is advantageous in that an increased number of connections can be made between the upper and lower boards.

## Claims

1. A circuit board assembly comprising first and second circuit boards (10, 12) arranged parallel to each other, and comb connector means (20) having a plurality of conductive connector elements (21) providing a connection between conducting tracks adjacent an edge of the first circuit board (10) and conducting tracks adjacent an edge of the second board (12); said plurality of conductive elements (21) of said comb connector means (20) comprising originally having been interconnected by an integral spine (22), the spine (22) being broken in at least one place to isolate one or more conductive elements from adjacent elements.

2. A method of assembling a circuit board assembly comprising the steps of providing first and second circuit boards (10, 12), electrically connecting the circuit boards (10, 12) to one another using a comb connector (20) comprising a plurality of conductive connecting elements interconnected by a spine (22), mounting components (16) upon the circuit boards (10, 12) whilst the circuit boards (10, 12) are oriented in a substantially coplanar manner, bending the connecting elements of the comb connector (20) until the boards are substantially parallel to one another, and breaking the spine (22) in at least one place to isolate one or more of the elements of the comb connector from adjacent elements thereof.

3. A method as claimed in Claim 2, characterised in that said components (16) and the connecting elements (21) of the comb connector are electrically connected to tracks of the circuit boards by a flow soldering technique.

4. A method as claimed in Claim 2 or Claim 3, characterised in that said spine (22) is broken after bending of the connecting elements (21) to position the boards (10, 11) parallel.

5. A method as claimed in Claim 2 or Claim 3, characterised in that said spine (22) is broken before bending of the connecting elements (21) to position the boards (10, 11) parallel.
